# EUROPÄISCHE PATENTSCHRIFT

(11) **EP 3 236 205 B1**
(45) Veröffentlichungstag und Bekanntmachung des Hinweises auf die Patenterteilung: **28.07.2021**
(21) Anmeldenummer: 17166161.4
(22) Anmeldetag: 12.04.2017
(51) Int. Cl.: G01C 15/00

(54) **ROTATIONSLASER**
ROTATION LASER
LASER ROTATIF

(30) Priorität: 18.04.2016 DE 102016107101
(43) Veröffentlichungstag der Anmeldung: 25.10.2017
(73) Patentinhaber: Status Pro Maschinenmesstechnik GmbH, 44866 Bochum (DE)
(72) Erfinder: FOLEY, David, 44799 Bochum (DE); KNODE, Burkhard, 45134 Essen (DE)
(74) Vertreter: Grundmann, Dirk

(56) Entgegenhaltungen:
- EP-A1- 0 682 280
- EP-A1- 2 789 973
- US-A- 5 029 791
- US-A- 6 055 046

## Beschreibung

### Gebiet der Technik

Die Erfindung betrifft einen Rotationslaser mit einem Gehäuse und einem im Gehäuse kardanisch aufgehängten, von Stellgliedern um zwei Achsen neigungsverstellbaren Pendelkörper einer Lasereinrichtung, die einen Strahldurchleitkanal mit einer am Boden des Strahldurchleitkanals angeordneten Emissionsfläche zur Emission eines Laserstrahls aufweist, wobei die Lasereinrichtung ferner ein Umlenkorgan trägt, das um eine Rotationsachse gegenüber der Lasereinrichtung drehantreibbar ist, um den parallel zur Rotationsachse durch den Strahldurchtrittskanal hindurchtretenden Laserstrahl zumindest teilweise in eine, in eine Richtung senkrecht zur Rotationsachse verlaufende Rotationsebene umzulenken, wobei Justiermittel vorgesehen sind, um den Laserstrahl aus einer radialen Versetztlage zur Rotationsachse in die Rotationsachse zu verstellen.

### Stand der Technik

Einen Rotationslaser, der in der Lage ist, einen in einer Rotationsebene rotierenden Laserstrahl und einen senkrecht dazu stehenden Laserstrahl zu erzeugen, beschreibt die DE 10 2008 035 480 A1. Die Verwendung eines Rotationslasers zur Vermessung der Rechtwinkligkeit von Großbauteilen wird in der DE 43 41 578 A1 beschrieben. Ein Rotationslaser wird auch in den US 6,055,046 A und EP 2 789 973 A1 beschrieben.

Ein gattungsgemäßer Rotationslaser besitzt ein Gehäuse, welches beispielsweise auf eine horizontale Grundfläche aufsetzbar ist. In dem Gehäuse befindet sich eine Lasereinrichtung, die eine Emissionsfläche aufweist, aus der ein Laserstrahl austritt. Die Lasereinrichtung trägt einen Rotationskörper, der beispielsweise ein Pentaprisma aufweist, um einen Teil eines Laserstrahls, der durch einen Strahldurchtrittskanal der Lasereinrichtung hindurchtritt, um einen rechten Winkel umzulenken, so dass er bei Rotation des Rotationskörpers um seine Rotationsachse in einer Rotationsebene umläuft. Aus dem aus der Emissionsfläche austretenden Laserstrahl wird ein weiterer Strahlanteil ausgekoppelt, der das Pentaprisma in axialer Richtung verlässt.

Der rotierende Laserstrahl läuft nur dann exakt in einer Ebene, wenn das Pentaprisma den Laserstrahl exakt um 90° umlenkt und der von der Emissionsfläche kommende Laserstrahl exakt in der Rotationsebene des Pentaprismas liegt. Im Stand der Technik sind Justiermittel vorgesehen, um die Rechtwinkligkeit zu justieren. Hierzu bedient man sich eines drehverstellbaren Prismas, durch das der Winkel des in die Horizontalebene austretenden Laserstrahls verstellt werden kann. Die Justierung der Koaxialität des Laserstrahls zur Rotationsachse erfolgt üblicherweise bei der Montage des Rotationslasers und ist - da die Lasereinrichtung im Zentrum des Gehäuses angeordnet ist und von Bauteilen umgeben ist, zu einem späteren Zeitpunkt nur nach einer Demontage der Lasereinrichtung möglich.

Verstellt sich die Koaxialität des Laserstrahls zur Rotationsachse dahingehend, dass der Laserstrahl einen seitlichen Versatz zur Rotationsachse besitzt, so vollzieht der rotierende Laserstrahl bei der Rotation des Pentaprismas um die Rotationsachse eine geringfügige Auf- und Abbewegung, die einer Sinusfunktion gehorcht. Dies führt bei einer Ausrichtung der Lasereinrichtung mittels Nivellierelementen in eine Senkrechte zur Horizontalebene zum sogenannten "Step-Fehler". Die EP 0 682 280 A1 und die US 5,029,791 A beschreiben X-Y-Positioniereinrichtungen, um eine Lichtquelle in eine optische Achse eines eine Linse aufweisenden optischen Gerätes zu bringen, wobei Rändelköpfe aufweisende Gewindespindeln verwendet werden.

### Zusammenfassung der Erfindung

Der Erfindung liegt die Aufgabe zugrunde, Maßnahmen anzugeben, mit denen der "Step-Fehler" einfacher als beim Stand der Technik zu korrigieren ist.

Gelöst wird die Aufgabe durch die in den Ansprüchen angegebene Erfindung.

Zunächst und im Wesentlichen ist vorgesehen, dass die Emissionsfläche in einer Verstellebene gegenüber der Rotationsachse verstellbar ist. Die Verstellebene verläuft senkrecht zur Rotationsachse. Es sind Justierelemente vorgesehen, die in der Lage sind, einen Emissionsflächenträger in der Verstellebene zu verlagern. Hierzu umfassen die Justierelemente einen eine Anlagefläche aufweisenden Emissionsflächenträger, der an einer Gegenanlagefläche des Pendelkörpers anliegt. Die Justage erfolgt mittels Justierschrauben, durch deren Drehung der Emissionsflächenträger gegenüber dem Pendelkörper verlagerbar ist. Bevorzugt liegen sich zwei Justierschrauben gegenüber, wobei bevorzugt insgesamt vier jeweils um 90° in einer Ebene senkrecht zur Rotationsachse lageversetzt zueinander liegende Justierschrauben vorgesehen sind. Die Justierschrauben stecken in Gewindeöffnungen des Pendelkörpers und wirken bevorzugt gegen einen in eine Höhlung des Pendelkörpers ragenden Fortsatz des Emissionsflächenträgers. Der Fortsatz des Emissionsflächenträgers kann den Strahldurchtrittskanal aufweisen, in dem sich ein Kollimator befinden kann. Am Emissionsflächenträger können Nivellierelemente befestigt sein, die von elektrischen Libellen ausgebildet sind. Die Nivellierelemente sind in der Lage, einen Neigungswinkel des Emissionsflächenträgers gegenüber einer Vertikalen in zwei senkrecht zueinander stehenden Schwenkrichtungen zu erfassen. In einer bevorzugten Ausgestaltung ist vorgesehen, dass die Anlagefläche kraftbeaufschlagt an der Gegenanlagefläche anliegt. Zur Erzeugung der Anlagekraft sind bevorzugt Federelemente vorgesehen. Die Federelemente können von Wendelgangdruckfedern oder Tellerfedern ausgebildet sein, die sich am Kopf einer Befestigungsschraube abstützen, mit denen der Emissionsflächenträger am Pendelkörper befestigt ist. Es können vier derartige Befestigungsschrauben vorgesehen sein, die örtlich einem Flanschbereich des Emissionsflächenträgers zugeordnet sind, der an einem Flanschbereich des Pendelkörpers anliegt. Der Flanschbereich des Pendelkörpers besitzt Gewindebohrungen, in die jeweils ein Gewindeschaft der Befestigungsschraube eingeschraubt ist. Die Stirnflächen der Gewindeschäfte der Befestigungsschraube können dabei gegen einen Boden der als Sackloch ausgebildeten Gewindebohrungen stoßen. Der Kopf der Gewindeschraube ist von einer Anlagefläche des Federelementes räumlich beabstandet. Der Schaft der Gewindeschraube durchgreift eine Schraubendurchtrittsöffnung des Emissionsflächenträgers, die einen deutlich größeren Durchmesser aufweist als der Gewindeschaft. Als Folge dessen kann der Emissionsflächenträger entlang der Gegenanlagefläche in einer senkrecht zur Richtung des Laserstrahls verlaufenden Richtung in die beiden Richtungen der Ebene verschoben werden. Dies erfolgt durch Drehen einer oder mehrerer der Justierschrauben. Erfindungsgemäß werden innerhalb des Gehäuses Schraubwerkzeugdurchtrittskanäle ausgebildet, die mit den Gewindeöffnungen fluchten, in denen die Justierschrauben stecken. Die Schraubwerkzeugdurchtrittskanäle werden von einer Vielzahl von Schraubwerkzeugdurchtrittsöffnungen ausgebildet, die sich in der Wand des Gehäuses oder eine Platine oder im Boden eines Batteriefachs befinden können. Durch diese Öffnungen kann ein Schraubwerkzeug hindurchgesteckt werden, mit dem die jeweilige Justierschraube gedreht werden kann. In einer Weiterbildung der Erfindung wird die Emissionsfläche, die dem Boden des Strahldurchtrittskanals zugeordnet ist, von einer Blendenöffnung gebildet, die einen Durchmesser von 1µm bis 10µm aufweist. Die Blendenöffnung wird von der Rückseite, also mit auf der vom Kollimator weg weisenden Seite durch einen Laserstrahl beaufschlagt, wobei der Laserstrahl mittels eines Lichtwellenleiters von einem Halbleiter-Laser, der gehäusefest angeordnet ist, zur Lasereinrichtung geleitet wird. Innerhalb des Lichtwellenleiters erfolgt eine Vielfachreflektion des Laserstrahls, so dass eine Homogenisierung des Strahlquerschnitts stattfindet und die Blendenöffnung im Wesentlichen homogen beleuchtet wird.

### Kurze Beschreibung der Zeichnungen

Im Folgenden wird die Erfindung anhand eines Ausführungsbeispiels im Detail erläutert. Es zeigen:

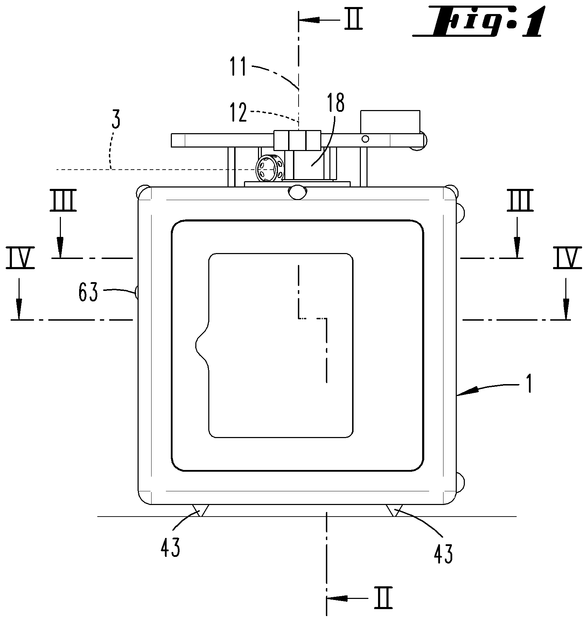

- Fig. 1: eine Ansicht auf das Gehäuse eines Rotationslasers,

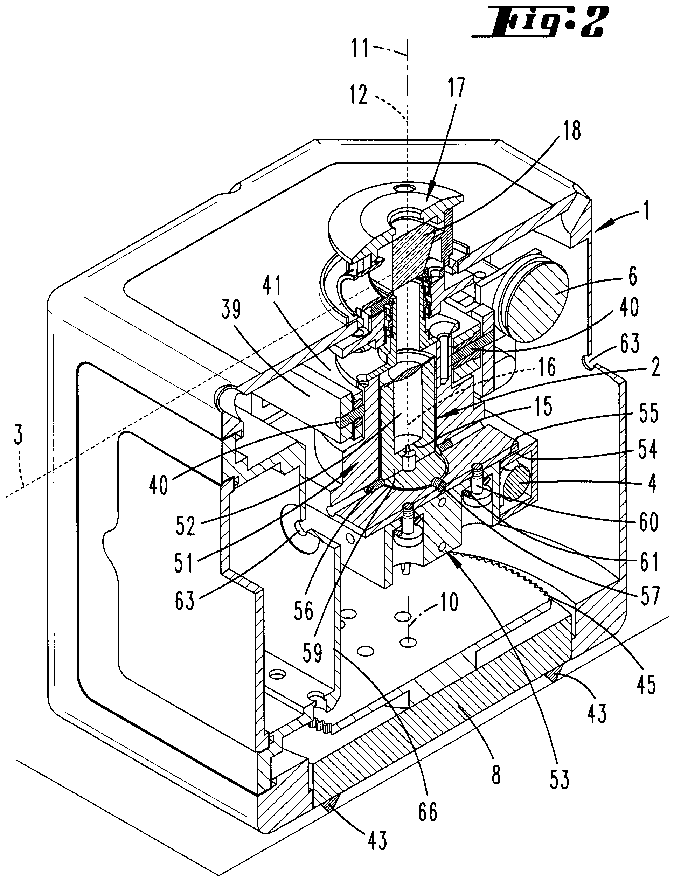

- Fig. 2: einen perspektivischen Aufbruch entlang der Aufbruchlinie II-II in Figur 1,

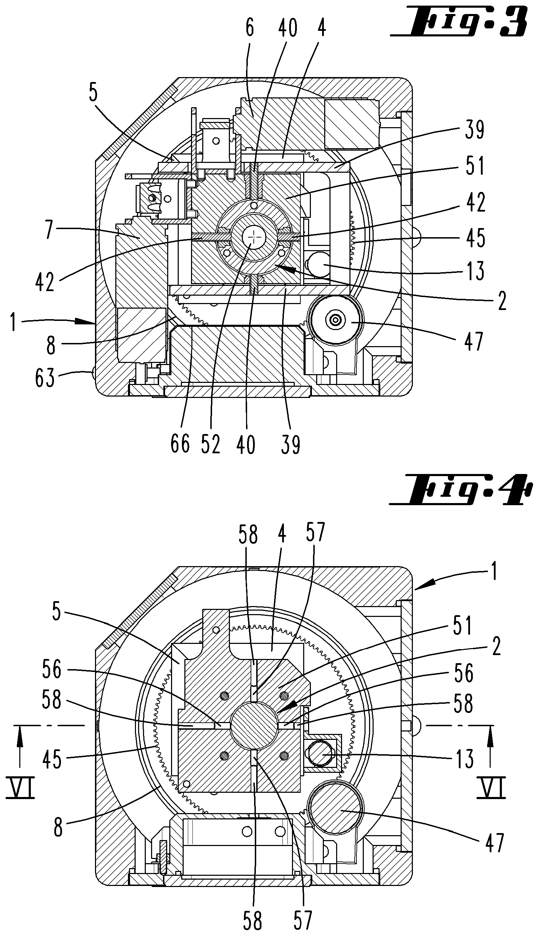

- Fig. 3: den Schnitt gemäß der Linie III-III in Figur 1,
- Fig. 4: den Schnitt gemäß der Linie IV-IV in Figur 1,

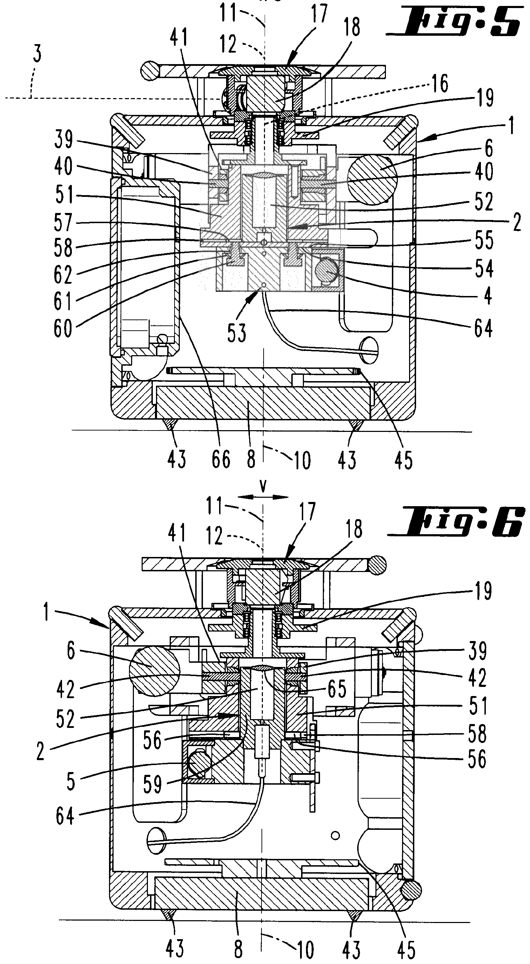

- Fig. 5: den Schnitt gemäß der Aufbruchfläche in Figur 2,
- Fig. 6: den Schnitt gemäß der Linie VI-VI in Figur 4,

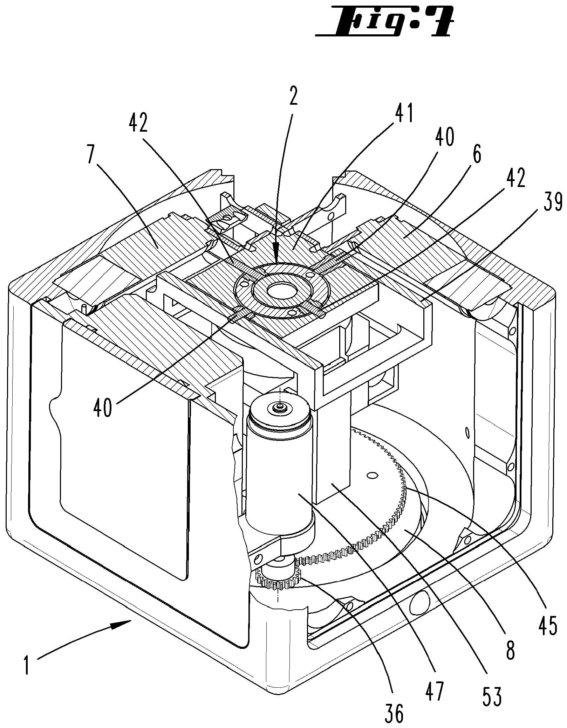

- Fig. 7: eine perspektivische Darstellung mit Blick auf die Schnittfläche gemäß Figur 3,

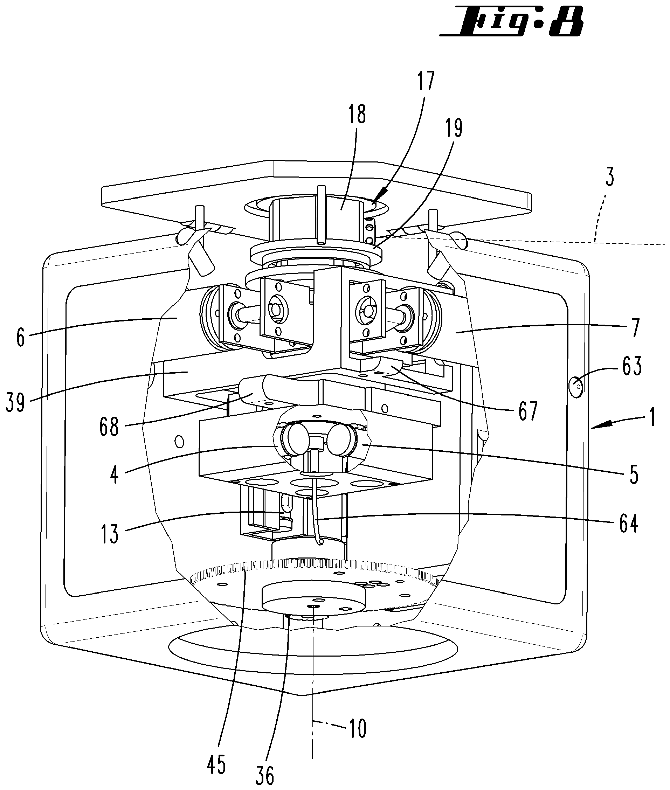

- Fig. 8: eine perspektivische Ansicht von einem Aufbruch, wobei die Bodenplatte 8 nicht dargestellt ist.

### Beschreibung der Ausführungsformen

Der Rotationslaser besitzt ein im Wesentlichen quaderförmiges Gehäuse 1 mit einer Unterseite, die eine Bodenplatte 8 ausbildet, mit der das Gehäuse 1 auf einer Aufstellfläche aufstellbar ist. Innerhalb des Gehäuses 1 befindet sich eine Leiterplatte mit einer elektronischen Schaltung, die eine Steuereinrichtung ausbildet. Innerhalb des Gehäuses 1 befindet sich darüber hinaus eine Lasereinrichtung 2. Die Lasereinrichtung 2 ist innerhalb des Gehäuses 1 kardanisch um einen Lagerpunkt aufgehängt. Hierzu ist eine Kardanaufhängung 39 fest mit dem Gehäuse 1 verbunden. Die Kardanaufhängung 39 besitzt zwei sich gegenüberliegende Befestigungsschenkel, von denen jeweils eine Gelenkachse 40 abragt. An der Gelenkachse 40 ist ein Kardanringkörper 41 befestigt, der um die Gelenkachse 40 in einer Horizontalrichtung verschwenkbar ist.

In einer Öffnung des Kardanringkörpers 41 befindet sich ein Pendelkörper 51, der Teil der Lasereinrichtung 2 ist. Der Pendelkörper 51 ist um eine weitere Gelenkachse 42, die quer zur Gelenkachse 40 verläuft, gegenüber dem Kardanringkörper 41 verschwenkbar.

Die Neigungswinkel des Pendelkörpers 51 bzw. der Lasereinrichtung 2 lässt sich mittels zwei Stellmotoren 6, 7 verstellen. Im Ausführungsbeispiel sind die Verstellmotoren am Kardanringkörper 41 befestigt. Der Stellmotor 6 ist in der Lage, den Pendelkörper 51 gegenüber dem Kardanringkörper 41 um die Gelenkachse 42 zu verschwenken. Mit dem Stellmotor 7 lässt sich der Kardanringkörper 41 um die Gelenkachse 40 gegenüber der gehäusefesten Kardanaufhängung 39 verschwenken. Bei den Stellmotoren 6, 7 handelt es sich um Elektromotoren, die mit einem Untersetzungsgetriebe auf eine Schwenkachse wirken, auf der ein Band oder eine Zuglasche gewickelt ist, die mit einem Vorsprung 67, 68 entweder der Kardanaufhängung 39 oder des Pendelkörpers 51 verbunden ist.

Die Lasereinrichtung 2 trägt einen Kopf 17, der um eine Rotationsachse 11, die bevorzugt durch das Kreuz von Gelenkachse 42 und Gelenkachse 40 verläuft, drehbar ist. Hierzu dient ein Rotationsantrieb 19, der den Kopf 17 in eine gleichmäßige Rotationsbewegung um die Rotationsachse 11 bringen kann.

Der Kopf 17 trägt ein Pentaprisma 18 mit dem ein in etwa koaxial zur Rotationsachse 11 verlaufender Laserstrahl 16 um 90° in die Rotationsebene umgelenkt wird, so dass ein in einer Rotationsebene rotierender Laserstrahl 3 entsteht.

Das Pentaprisma 18 bildet einen Strahlteiler. Der Laserstrahl 16 tritt teilweise auch als axialer Laserstrahl 12 aus dem Kopf 17 des Rotationslasers heraus.

Der Pendelkörper 51 besitzt eine Höhlung, in der sich ein Fortsatz 59 eines Emissionsflächenträgers 53 befindet. Die Höhlung des Pendelkörpers 51 besitzt einen im Wesentlichen kreisrunden Querschnitt. Die Außenwandung des Fortsatzes 59 ist ebenfalls im Querschnitt kreisrund und besitzt einen radialen Abstand zur Innenwandung der Höhlung des Pendelkörpers 51.

Eine vom Kopf 17 weg weisende Stirnseite des Pendelkörpers 51 bildet eine Gegenanlagefläche 55. Die Gegenanlagefläche 55 verläuft in einer Ebene, zu der die Rotationsachse 11 senkrecht verläuft. Die Rotationsachse 11 verläuft etwa mittig durch die Höhlung des Pendelkörpers 51.

An der Gegenanlagefläche 55 stützt sich eine Anlagefläche 54 des Emissionsflächenträgers 53 ab, die von einem Flanschabschnitt des Emissionsflächenträgers 53 gebildet ist. In der Gegenanlagefläche 55 befinden sich mehrere, bevorzugt vier in gleichmäßiger Umfangsverteilung um die Rotationsachse 11 angeordnete Gewindesackbohrungen. In jede dieser Gewindesackbohrungen ist der Schaft einer Befestigungsschraube 60 eingedreht. Die Befestigungsschraube 60 durchgreift eine Schraubendurchtrittsöffnung 62 des Flanschabschnittes des Emissionsflächenträgers 53. Der Kopf der Schraube 60 besitzt einen bezogen auf die Erstreckungsrichtung der Schraube 60 axialen Abstand zu einer der Anlagefläche 54 gegenüberliegenden Abstützfläche, an der sich ein Federelement 61 mit einem seiner Enden abstützt. Das andere Ende des Federelementes 61 stützt sich am Schraubenkopf ab. Das Federelement, welches von einer Wendelgangdruckfeder gebildet sein kann, im Ausführungsbeispiel aber von einer Tellerfeder gebildet ist, ist vorgespannt und entfaltet eine Presskraft, mit der die Anlagefläche 54 gegen die Gegenanlagefläche 55 gepresst wird.

Die Kraft, mit der die beiden Flächen 54, 55 gegeneinander beaufschlagt werden, erzeugt eine Reibkraft, die überwunden werden muss, um den Emissionsflächenträger 53 quer zur Erstreckungsrichtung der Rotationsachse 11 gegenüber dem Pendelkörper 51 zu verschieben.

In der axialen Mitte weist der Emissionsflächenträger 53 den Strahldurchtrittskanal 52 auf, der mit einer Austrittslinse 65 versehen ist. Der Boden des Strahldurchtrittskanals 52 besitzt in seiner Mitte eine Öffnung 15, die einen Durchmesser von wenigen Mikrometern besitzt. Es handelt sich um eine Blende, durch die ein Laserstrahl 16 austreten kann, der in Richtung der Rotationsachse 11 in das Pentaprisma 18 eintritt und dort in den rotierenden Laserstrahl 3 und den stehenden axialen Laserstrahl 12 aufgeteilt wird.

Die Erzeugung des Laserstrahls erfolgt im Ausführungsbeispiel an einer Stelle, die entfernt vom Emissionsflächenträger 53 angeordnet ist durch einen fest mit dem Gehäuse verbundenen Laser. Der Laserstrahl wird über einen Lichtwellenleiter 64 zum Boden des Strahldurchtrittskanals 52 geleitet. Ein Endabschnitt des Lichtwellenleiters 64 steckt hierzu in einer axialen Einstecköffnung des Emissionsflächenträgers 53. Die Stirnfläche des Lichtwellenleiters 64 befindet sich unmittelbar unterhalb der Öffnung 15, so dass das aus der Stirnseite des Lichtwellenleiters 64 heraustretende Laserlicht durch die von der Öffnung 15 gebildete Blende austreten kann.

Indem der Emissionsflächenträger 53 in eine Richtung quer zur Rotationsachse 11 verschoben werden kann, lässt sich die Emissionsfläche 15 von einer Versatzstellung in Richtung des Doppelpfeils V in eine Koaxialstellung zur Rotationsachse 11 bringen. Hierzu sind Justierschrauben 56, 57 vorgesehen, die sich paarweise gegenüberliegen und jeweils um 90° versetzt bezogen auf die Rotationsachse 11 sind. Die Justierschrauben 56, 57 stecken in quer zur Rotationsachse 11 verlaufenden Gewindeöffnungen 58. Mit den Justierschrauben 56, 57 lässt sich die Position des Emissionsflächenträgers 53 in zwei senkrecht zueinander stehenden Richtungen derart gegenüber dem Pendelkörper 51 bzw. der Rotationsachse 11 verlagern, dass die Emissionsfläche 15, also die Austrittsöffnung für den Laserstrahl 16, in die Rotationsachse 11 gebracht werden kann.

Die Justage kann im vollständig montierten Zustand durchgeführt werden, da Leiterplatten, Gehäusewände und/oder der Boden eines Batteriefachs 66 Schraubwerkzeugdurchtrittsöffnungen 63 ausbilden. Schraubwerkzeugdurchtrittsöffnungen 63 fluchten jeweils mit den ihnen zugeordneten Gewindeöffnungen 58, so dass Schraubwerkzeugdurchtrittskanäle ausgebildet sind, durch die die Klinge eines Schraubendrehers von der Gehäuseaußenseite her eingesteckt werden kann, um die Justierschrauben 56, 57 zu verstellen.

## Patentansprüche

1. Rotationslaser mit einem Gehäuse (1) und einem im Gehäuse (1) kardanisch aufgehängten, von Stellgliedern (6, 7) um zwei Achsen (40, 42) neigungsverstellbaren Pendelkörper (51) einer Lasereinrichtung (2), die einen Strahldurchleitkanal (52) mit einer am Boden des Strahldurchleitkanals (52) angeordneten Emissionsfläche (15) zur Emission eines Laserstrahls (16) aufweist, wobei die Lasereinrichtung (2) ferner ein Umlenkorgan (18) trägt, das um eine Rotationsachse (11) gegenüber der Lasereinrichtung (2) drehantreibbar ist, um den parallel zur Rotationsachse (11) durch den Strahldurchtrittskanal (52) hindurchtretenden Laserstrahl (16) zumindest teilweise in eine in eine Richtung senkrecht zur Rotationsachse (11) verlaufende Rotationsebene umzulenken, wobei Justierelemente (53, 55, 57) vorgesehen sind, um den Laserstrahl (16) aus einer radialen Versetztlage (V) zur Rotationsachse (11) in die Rotationsachse (11) zu verstellen, **dadurch gekennzeichnet, dass** die Emissionsfläche (15) in einer senkrecht zur Rotationsachse (11) verlaufenden Verstellebene gegenüber der Rotationsachse (11) verlagerbar ist,
wobei die Justierelemente einen eine Anlagefläche (54) aufweisenden Emissionsflächenträger (53), der an einer Gegenanlagefläche (55) des Pendelkörpers (51) anliegt, umfassen;
wobei das Verstellen mittels Justierschrauben (56, 57), durch deren Drehung der Emissionsflächenträger (53) gegenüber dem Pendelkörper (51) verlagerbar ist, erfolgt;
wobei die Justierschrauben (56, 57) in Gewindeöffnungen des Pendelkörpers (51) stecken;
wobei innerhalb des Gehäuses Schraubwerkzeugdurchtrittskanäle ausgebildet sind, die mit den Gewindeöffnungen fluchten, in denen die Justierschrauben (56, 57) stecken, wobei die Schraubwerkzeugdurchtrittskanäle von einer Vielzahl von Schraubwerkzeugdurchtrittsöffnungen (63) ausgebildet sind, die sich in der Wand des Gehäuses oder einer Platine oder im Boden eines Batteriefachs befinden und
durch die ein Schraubwerkzeug hindurchgesteckt werden kann, mit dem die jeweilige Justierschraube (56, 57) gedreht werden kann.

2. Rotationslaser nach Anspruch 1, **dadurch gekennzeichnet, dass** paarweise sich gegenüberliegende Justierschrauben (56, 57) in Gewindeöffnungen (58) des Pendelkörpers (51) stecken und gegen einen in eine Höhlung des Pendelkörpers (51) ragenden Fortsatz (59) des Emissionsflächenträgers (53) wirken.

3. Rotationslaser nach einem der vorangehenden Ansprüche, **gekennzeichnet durch** der Lasereinrichtung (2) zugeordnete Nivellierelemente (4, 5) zur Ausrichtung der Rotationsachse (11) in eine senkrecht zur Horizontalebene stehende Richtung.

4. Rotationslaser nach einem der Ansprüche 2 oder 3, **gekennzeichnet durch** eine im Fortsatz (59) angeordnete Kollimatorlinse (65).

5. Rotationslaser nach einem der vorangehenden Ansprüche, **gekennzeichnet durch** Federelemente (61) zur Erzeugung eines Anpressdrucks, mit dem die Anlagefläche (54) die Gegenanlagefläche (55) in Richtung einer Flächennormalen federkraftbeaufschlagt.

6. Rotationslaser nach Anspruch 5, **dadurch gekennzeichnet, dass** die Federelemente (61) vom Kopf einer eine Schraubendurchtrittsöffnung (62) durchgreifenden Schraube (60) widergelagert sind.

7. Rotationslaser nach einem der vorangehenden Ansprüche, **dadurch gekennzeichnet, dass** der Laser ortsfest gegenüber dem Gehäuse (1) angeordnet ist und mit einem Lichtwellenleiter (64) mit dem Emissionsflächenträger (53) wirkverbunden ist.

8. Rotationslaser nach einem der vorangehenden Ansprüche, **dadurch gekennzeichnet, dass** die Emissionsfläche (15) von einer Blendenöffnung gebildet ist, die von der Stirnfläche eines Lichtwellenleiters (64) beleuchtet ist.

## Claims

1. Rotary laser comprising a housing (1) and a pendulum body (51) of a laser device (2) that is gimbal mounted in the housing (1) and the inclination of which can be adjusted about two axes (40, 42) by actuators (6, 7), which laser device has a beam passage channel (52) having an emission surface (15) arranged on the bottom of the beam passage channel (52) for emitting a laser beam (16), the laser device (2) also carrying a deflection member (18) which can be rotationally driven about an axis of rotation (11) with respect to the laser device (2) in order to deflect the laser beam (16) passing through the beam passage channel (52) in parallel with the axis of rotation (11) at least partially into a plane of rotation extending in a direction perpendicular to the axis of rotation (11), adjusting elements (53, 55, 57) being provided in order to adjust the laser beam (16) from a radial offset position (V) with respect to the axis of rotation (11) into the axis of rotation (11), **characterised in that** the emission surface (15) can be moved relative to the axis of rotation (11) in an adjustment plane extending perpendicularly to the axis of rotation (11),
the adjusting elements comprising an emission surface carrier (53) which has a contact surface (54) and which is in contact with a mating contact surface (55) of the pendulum body (51);
the adjustment being carried out by means of adjusting screws (56, 57), the rotation of which allows the emission surface carrier (53) to be moved relative to the pendulum body (51);
the adjusting screws (56, 57) being inserted into threaded openings in the pendulum body (51);
screwing tool passage channels being formed within the housing, which channels are aligned with the threaded openings in which the adjusting screws (56, 57) are inserted, the screwing tool passage channels being formed by a plurality of screwing tool passage openings (63) which are located in the wall of the housing or a circuit board or in the bottom of a battery compartment and through which a screwing tool can be inserted, by means of which the relevant adjusting screw (56, 57) can be turned.

2. Rotary laser according to claim 1, **characterised in that** adjusting screws (56, 57) lying opposite one another in pairs are inserted in threaded openings (58) of the pendulum body (51) and act against an extension (59) of the emission surface carrier (53) that protrudes into a cavity in the pendulum body (51).

3. Rotary laser according to any of the preceding claims, **characterised by** levelling elements (4, 5) associated with the laser device (2) for aligning the axis of rotation (11) in a direction perpendicular to the horizontal plane.

4. Rotary laser according to either claim 2 or claim 3, **characterised by** a collimator lens (65) arranged in the extension (59).

5. Rotary laser according to any of the preceding claims, **characterised by** spring elements (61) for generating a contact pressure, by means of which the contact surface (54) applies spring force to the mating contact surface (55) in the direction of a surface normal.

6. Rotary laser according to claim 5, **characterised in that** the spring elements (61) are in abutment against the head of a screw (60) passing through a screw passage opening (62).

7. Rotary laser according to any of the preceding claims, **characterised in that** the laser is arranged so as to be stationary with respect to the housing (1) and is operatively connected to the emission surface carrier (53) by means of an optical waveguide (64).

8. Rotary laser according to any of the preceding claims, **characterised in that** the emission surface (15) is formed by an aperture which is illuminated by the end face of an optical waveguide (64).

## Revendications

1. Laser rotatif avec un boîtier (1) et un corps pendulaire (51) d'un dispositif laser (2), lequel corps pendulaire est suspendu de façon cardanique dans le boîtier (1) et peut être réglé en inclinaison autour de deux axes (40, 42) par des actionneurs (6, 7), le dispositif laser (2) présentant un canal de passage de faisceau (52) avec, agencée au fond du canal de passage de faisceau (52), une surface d'émission (15) pour l'émission d'un faisceau laser (16), le dispositif laser (2) portant en outre un organe de déviation (18) qui peut être entraîné en rotation autour d'un axe de rotation (11) par rapport au dispositif laser (2) pour dévier le faisceau laser (16) qui traverse le canal de passage du faisceau (52) parallèlement à l'axe de rotation (11), au moins partiellement dans un plan de rotation s'étendant dans une direction perpendiculaire à l'axe de rotation (11), des éléments de réglage (53, 55, 57) étant prévus pour déplacer le rayon laser (16) d'une position de décalage radial (V) par rapport à l'axe de rotation (11) dans l'axe de rotation (11), **caractérisé en ce que** la surface d'émission (15) peut être déplacée par rapport à l'axe de rotation (11) dans un plan de déplacement s'étendant perpendiculairement à l'axe de rotation (11),
dans lequel les éléments de réglage comprennent un support de surface d'émission (53) ayant une surface de butée (54) et qui est en butée contre une surface de contre-butée (55) du corps pendulaire (51);
dans lequel le réglage est effectué au moyen de vis de réglage (56, 57) par la rotation desquelles le support de surface d'émission (53) est déplaçable par rapport au corps pendulaire (51);
dans lequel les vis de réglage (56, 57) sont insérées dans des ouvertures filetées du corps pendulaire (51);
dans lequel des canaux de passage d'outil de vissage sont formés à l'intérieur du boîtier, qui sont alignés avec les ouvertures filetées dans lesquelles sont insérées les vis de réglage (56, 57), les canaux de passage d'outil de vissage étant formés par une pluralité d'ouvertures de passage d'outil de vissage (63) qui sont situées dans la paroi du boîtier ou dans une carte de circuit imprimé ou dans le fond d'un compartiment de batterie, et
à travers lesquels peut être inséré un outil de vissage avec lequel peut être tournée la vis de réglage respective (56, 57).

2. Laser rotatif selon la revendication 1, **caractérisé en ce que** des paires de vis de réglage opposées (56, 57) sont insérées dans des ouvertures filetées (58) du corps pendulaire (51) et agissent contre un prolongement (59) du support de surface d'émission (53) faisant saillie dans une cavité du corps pendulaire (51).

3. Laser rotatif selon l'une des revendications précédentes, **caractérisé par** des éléments de nivellement (4, 5) associés au dispositif laser (2) pour orienter l'axe de rotation (11) dans une direction perpendiculaire au plan horizontal.

4. Laser rotatif selon l'une des revendications 2 ou 3, **caractérisé par** une lentille collimatrice (65) agencée dans le prolongement (59).

5. Laser rotatif selon l'une des revendications précédentes, **caractérisé par** des éléments de ressort (61) pour générer une pression de contact avec laquelle la surface de butée (54) agit élastiquement sur la surface de contre-butée (55) dans la direction d'une normale à la surface.

6. Laser rotatif selon la revendication 5, **caractérisé en ce que** les éléments de ressort (61) sont supportés en appui par la tête d'une vis (60) passant par une ouverture de passage de vis (62).

7. Laser rotatif selon l'une des revendications précédentes, **caractérisé en ce que** le laser est agencé de manière fixe par rapport au boîtier (1) et est relié fonctionnellement au support de surface d'émission (53) au moyen d'un guide d'onde optique (64).

8. Laser rotatif selon l'une des revendications précédentes, **caractérisé en ce que** la face d'émission (15) est formée par une ouverture qui est éclairée par la face d'extrémité d'un guide d'onde optique (64).
